# NEW EUROPEAN PATENT SPECIFICATION

(11) **EP 0 153 719 B2**
(45) Date of publication and mention of the opposition decision: **27.10.1993**
(45) Mention of the grant of the patent: 14.11.1990
(21) Application number: 85102009.9
(22) Date of filing: 23.02.1985
(51) Int. Cl.: H03G 3/20

(54) **Method and apparatus for controlling the gain of an amplifier system**
Verfahren und Gerät zur Verstärkungsregelung eines Verstärkersystems
Méthode et appareil pour commander le gain d'un système amplificateur

(30) Priority: 01.03.1984 US 585048
(43) Date of publication of application: 04.09.1985
(73) Proprietor: HONEYWELL INC., Minneapolis Minnesota 55408 (US)
(72) Inventor: Olsen, Arthur M., Pennsburg Pennsylvania 18073 (US)
(74) Representative: Rentzsch, Heinz, Dipl.-Ing.

(56) References cited:
- EP-A- 0 086 514
- DE-A- 3 206 114
- DE-C- 2 942 106
- FR-B- 1 602 358
- GB-A- 2 068 694

## Description

The invention relates to a method for controlling the gain of an amplifier system as described in the precharacterizing portion of the independent claims.

GB-A 20 68 694 describes a waveform analyzer in particular for video broadcast signals wherein a digitally programmable amplifier is used for variably amplifying the input signal such that the signal analyzer itself is supplied with a constant amplitude input signal which makes optimum use of the total dynamic operating range of the analyzer. The analyzer provides digital output signals depending on the amplitude and offset of its analog input signal and feeds these gain and offset data into an instruction memory associated with a microprocessor. Under the command of timing signals provided by the microprocessor the instruction memory feeds gain data to the programmable amplifier in order to change its gain such that a constant amplitude output signal of the amplifier is achieved. The instruction memory furthermore provides offset data to a digital-to-analog converter which supplies a summing amplifier at the input of the variable gain amplifier with an analog offset voltage which is added to the analog input signal such that the offset is removed. Dependent upon the peak-to-peak amplitude of the analog input signal the variable gain amplifier is switched to different gain values such that its output signal is maintained at a constant level.

DE-C 29 42 106 shows a hybrid automatic gain control circuit including the features of the pre-characterizing portion of the independent claims. This gain control system has a coarse analog gain adjustment section producing discrete increments of gain and a fine digital gain adjustment section. The analog gain adjustment section consists of four analog amplifier stages providing analog gain of 8A, 4A, 2Aand A, respectively, which are switched in or out of the path of the coarse input signal by a four bit number stored in a register to provide 16 possible gain combinations. The output of the coarse analog gain adjustment section is fed to an A/D converter, whose output signal is multiplied by a factor fA in a subsequent multiplier, where f is in the range of -1 to +1. The multiplying factor f is determined by a ten bit digital word coming from a control circuit, e.g. a microprocessor. This control circuit also generates the four bit word for controlling the coarse analog amplifying section. The coarse analog gain control section brings the signal within the range of the subsequent A/D converter while the digital gain control circuit at the output of said converter provides a steady precise output level of the digital signal as it is required at the input of several signal handling apparatus such as a modem.

Contrary to this the present invention relates to an amplifier system which does not provide a constant amplitude output signal but provides a predetermined overall system gain.

If a relatively large input signal is fed to an analog amplifier, this amplifier might be saturated and therewith operating in its non-linear range of amplification. On the other hand if very small input signals have to be amplified, the amplifier also may work in a nonlinear portion of its operating range and the ratio of the input signal to the inherent noise of the amplifier is unfavorable. The same problem is known from analog-to-digital converters where analog input signals exceeding the operating range of the converter cannot be digitized properly and whereat very small input signals lead to an unstable conversion at the lower end of the operating range.

The invention, therefore, looks for an amplifier system in which an analog amplifier is not only prevented from becoming saturated and always operates in its preferred linear range for all values of the input signal, but in addition provides a constant overall system gain level which does not change dependent on the input signal level. This object is achieved by the method as characterized in claim 1. Preferred improvements of this method are subject of claims 2 and 3. The invention furthermore discloses a preferred amplifier system for performing this method which is characterized in claim 4 and its dependent claims.

According to the invention, the desired predetermined overall system gain is divided into two components with one component being effected by the variable gain analog amplifier and the other component being effected by a digital computer. Conversion means are provided for converting the output signal of this analog amplifier into a digital representation of the amplified input signal, which digital representation then is fed to the computer. By selecting a gain value which depends on the value of the input signal, the analog amplifier can be rendered operating in its linear range of operation, and the missing part of the total gain is accomplished by the digital computer. The input signal is applied to the variable gain amplifier, the output signal of the amplifier is converted to a digital representation thereof and this digital representation is supplied to the digital computer to be used in computing a digital output in accordance with a predetermined system signal gain. Simultaneously the digital computer develops a gain selection control signal for selecting a signal gain of the amplifier to maintain the predetermined system signal gain. If the signal amplifier system includes a combined analog amplifier and analog-to-digital converter having a plurality of selectable signal gains, the gain orconver- sion factor of the converter is controlled by the digital computer. In a preferred embodiment a non-volatile memory stores data on the signal gains of said variable gain amplifier or converter and the digital computer connected to said converter and said memory computes (i) a digital output signal representative of the analog input signal in accordance with a predetermined system signal gain and (ii) a control signal for selecting a signal gain of said amplifier or converter to maintain the predetermined system signal gain.

It should be noted that an analog amplifier having no gain control function provides a constant gain as long as it works in its linear range of operation. FR-A 16 02 358 describes a two-stage analog amplifier where the total gain is distributed between two subsequent amplifier stages and this distribution can be changed. The amplifier is in particular useful for analog computing circuits. The input signal is fed to a first attenuating circuit followed by a first operational am- plifierwhich feeds a signal-handling circuit such as an analog calculating circuit providing multiplication or division of its input signal by another signal such that the output signal of this signal-handling circuit is smaller than its input signal. This output signal then is fed through a second attenuating circuit to a second operational amplifier having connected in parallel therewith a third attenuating circuit. The output of the second operational amplifier is supplied to a utilization circuit or load. At least the first and third attenuating circuits have control inputs for changing their amount of attenuation. Associated control signals are provided by a voltage comparison circuit which at its signal input receives a converted version of the system input signal and at its reference inputs receives three different DC reference voltages. By simultaneously changing the attenuation of the series-connected first attenuator and the parallel-connected third attenuator, the total gain of the system can be maintained constant although the input signal of the signal-handling circuit received from the output of the first operational amplifier is varied in accordance with the commanded attenuation value of the first attenuator circuit.

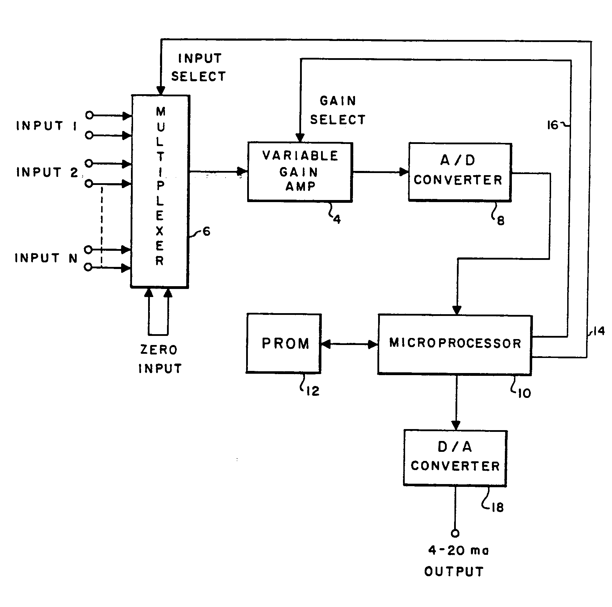

A better understanding of the present invention may be had when the following detailed description is read in connection with the accompanying drawing, in which the single figure is a block diagram illustration of an example of an apparatus providing a compensation of a signal amplifier system having a variable gain amplifier4 utilizing the method of the present invention to achieve a constant overall system signal gain. The variable gain amplifier 4 is supplied with an input from a multiplexer 6 which is arranged to sequentially connect selected ones of a plurality of inputs, input 1, input 2, ... n to the amplifier4. Additionally, the multiplexer 6 is also arranged to periodically connect a zero input to the amplifier 4 to provide a means for monitoring the transient noise or offset of the amplifier system. The output of the variable gain amplifier4 is applied to an analog-to-digital (A/D) converter 8 to be converted to a digital representation thereof. The output of the A/D converter 8 is applied as an input to a digital computer, e.g., microprocessor 10.

A non-volatile memory, e.g., PROM 12, is connected to the microprocessor 10 to store the instructions used by the microprocessor 10 in effecting the method of the present invention. The microprocessor 10 also controls the input selection of the multiplexer 6 via input select line 14 and the gain of the variable gain amplifier 4 via gain select line 16. An output of the microprocessor 10 provides a digital representation of the selected input of the multiplexer 6 after compensation by the microprocessor 10 to effect a constant gain of the signal amplifying system. This microprocessor output is applied to digital-to-analog (D/A) converter 18 to be converted to a conventional 4-20 mA output signal which can be used to produce a control function, as is well-known in the art, for associated devices (not shown).

The method utilized by the present invention basically involves the operation of a two-stage amplifier system which has a constant value of overall signal gain but where the distribution or allocation of the signal gain is dynamically and automatically shifted between the first and second stages as required because of the changing amplitude of the input signal. Thus, this shift of the signal gain produces the best overall performance of the system while maintaining a constant signal gain. In the illustrated embodiment of the invention, the first stage of the amplifiersystem includes a variable gain analog amplifier 4 having a plurality of signal gain values which can be individually selected since the possible range of the input signal amplitude coupled with the resolution and signal-to- noise requirements of the system are such that no single value of amplifier gain can be realistically used. For example, a high signal gain is desirable for low amplitude input signals while a low signal gain is required for high amplitude input signals to prevent saturation of the amplifier 4.

The second stage of the amplifier system is a digital computer represented by the microprocessor 10. Depending on the value of the output of the A/D converter 8, the computer 10 selects the appropriate gain value of the variable gain amplifier 4. Concurrently, using stored data in the PROM 12 which defines the performance of the analog amplifier 4 at each of the selected gains, an output digital value from the computer 10 is computed which is equivalent to a signal which would have been produced by the variable gain amplifier 4 operating at its highest gain. This digital output signal is then applied to the D/A converter 18 to be converted and used as an input for associated equipment. Thus, the analog amplifier4 always operates at its optimal gain value with respect to the amplitude of its input signal. Any calculations by the digital computer 10 are simplified since they do not need to be different for each of the analog gains as it would be necessary for obtaining a constant level output signal. Separate calibration curves for each gain are eliminated. The microprocessor 10 at each selection of a new input signal by the multiplexer6 automatically adjusts its own gain in accordance with the level of the input signal at the particular input of the multiplexer.

In general, any analog-to-digital conversion method can be defined by a group of equations. Using a specific type ofA/D and amplifier combination, the following set of equations can be written to equate digital output of the A/D and amplifier pair to the analog input signal thereto. The equations used by the computer 10 are effective to provide a gain correction for high, medium ... and low amplitude input signals, e.g., an amplifier 4 and A/D converter pair 8 having three selectable signal gains (G), i.e., high medium and low. Thus, the equations are: 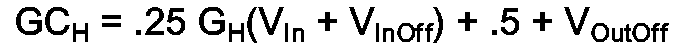 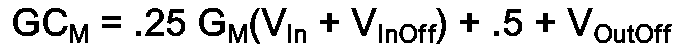 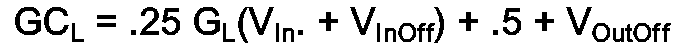 which V_{Inoff} and V_{outoff} are the offset signal levels for the input and output signals from the amplifier4. True zero input signals (Vᵢₙ=O) can be measured by selecting the zero input which would simplify the above equations to: 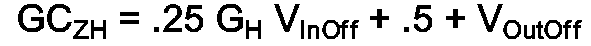 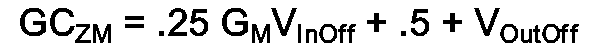 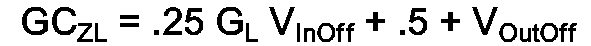 using these equations, the gain is corrected as follows:

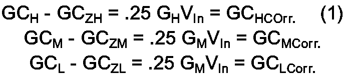

Solving for Vₗₙ in each of these three equations: Vₗₙ = GC_{HCorr.}/.25 ^{G}_{H} 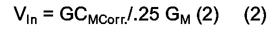 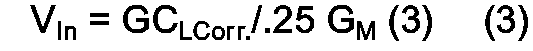 and finally substituting equations (2) and (3) for Vₗₙ in equation (1):

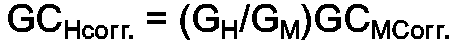

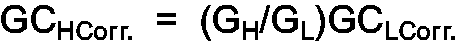

The ratios G_{H}/G_{M} and G_{H}/G_{L} are characterized data stored in the PROM 12 during the manufacturing of the system to be used by the digital computer 10 during the system compensation operation. In a typical example, the ampiifier4 would have three selectable gains, e.g., 20, 5 and 1.25.

Initially, when the system is turned on, the gain of the amplifier4 is initialized to its lowest value. Subsequently, the first input is selected by the multiplexer 6, and the output of the AID converter 8 is read by the computer 10. Based on the value of that output, the determination is made as to whether or not, the initial amplifier gain is correct. The system can either compensate from the lowest gain level or select the next gain level to improve resolution of the input signal and compensate from the higher gain level. The aforesaid compensation is preferably performed for each input selected by multiplexer 6. Further, the computer 10 can store each selected gain for each input in another memory and, subsequently, selects the prior stored gain when the corresponding input is again selected. Thus, the overall system gain is maintained while the amplifier gain is varied for optimum operation while the division of the system gain is automatically allocated by the computer 10 between the analog and digital stages of the system.

Accordingly a variable gain amplifier4 is adjusted to maintain its amplification within a linear range, i.e., to prevent saturation of the amplifier, by utilizing the output of an analog-to-digital converter 8, which is arranged to convert an analog output of the amplifier to a digital representation, by a digital computer 10 to effect the gain change of the amplifier. Concurrently, the output signal of the digital computer 10 representing the output signal from the analog-to-digital converter 8 is modified to produce a system output signal based on a constant overall gain of the system which is equivalent to the highest available gain from the amplifier. Thus, while the amplifier gain is adjusted by the computer in response to the amplitude of the input signal, the overall system gain is maintained at a level which would be available at the highest amplifier gain. The digital output of the system can subsequently be utilized as a control signal either directly or after a digital-to-analog conversion.

## Claims

1. A method for controlling the gain of an amplifier system comprising variable gain amplifying means (4), A/D conversion means (8) and a digital computer (10), whereat
a) system input signals are fed to a signal input of the variable gain amplifying means;
b) the output of said amplifying means is in communication with the digital computer via said A/D conversion means;
c) an output signal of the digital computer is used for controlling the gain of the variable gain amplifying means;
d) the overall gain of the amplifier system is divided into a first gain portion provided by the variable gain amplifying and analog to digital conversion means (4, 8) and a second gain portion provided by the digital computer (10);
e) the output signal of the amplifying and conversion means is a digital representation of the amplified input signal, which digital representation is fed as an input signal to said digital computer;
f) the digital computer selects a gain control signal for controlling the gain of the variable gain amplifying and conversion means such that this variable gain amplifying and conversion means operates in its linear range;
g) the amplified system output signal is taken from a signal output of the digital computer;
characterized in that
h) the digital computer selects said gain control signal depending on the value of said digital representation of the amplified input signal as provided at the output of the A/D conversion means (8);
i) depending on the selected gain for the variable gain amplifying and conversion means the digital computer selects an associated gain within the digital computer for its digital input signal such that the overall gain of the system is maintained at a predetermined constant overall system gain level.

2. The method according to claim 1, characterized by storing in a computer memory (12) the desired predetermined overall system gain and the available signal gains of the variable gain amplifying and conversion means (4, 8) and supplying the digital computer (10) with a control signal which together with the selected gain of the variable gain amplifying and conversion means provides the desired predetermined overall signal gain.

3. The method according to claim 1 or 2, characterized by selecting the gain of the variable gain amplifying and conversion means (4, 8) such that its output signal does not exceed a predetermined value and by increasing the digital representation provided by said variable gain amplifying and conversion means by means of the digital computer (10) to accomplish the predetermined overall gain of the system.

4. A signal amplifier system for performing the method according to any one of the preceding claims, said system comprising
a) variable gain amplifying and conversion means (4, 8);
b) a digital computer (10) controlling the gain of the amplifying and conversion means; and
c) an output providing the amplified input signal, wherein
d) the variable gain amplifying and analog-to-digital conversion means (4, 8) has a plurality of selectable signal gains;
e) the analog system input signal is fed to a signal input of the amplifying and conversion means (4, 8) and a digital representation of the amplified input signal provided at an output of the amplifying and conversion means is fed to a signal input of the digital computer (10);
f) the digital computer (10) provides at a control output (16) a gain control signal for controlling the gain of the amplifying and conversion means (4, 8) such that it operates in its linear range;
g) signal output means (18) of the digital computer (10) provide a system output signal;
characterized in that
h) the digital computer (10) selects said gain control signal depending on the value of said digital representation of the amplified system input signal as provided at the output of the A/D conversion means (8);
i) depending on the selected gain for the amplifying and conversion means the digital computer adjusts its own gain such that the overall gain of the system is maintained at a predetermined constant overall system gain level, and the system output signal corresponds to the system input signal amplified times the predetermined constant overall gain factor.

5. Apparatus according to claim 4, characterized in that the amplifying and analog-to-digital conversion means is an AID-converter (8) having a plurality of selectable signal gain factors.

6. Apparatus according to claim 4, characterized in that the amplifying and analog-to-digital conversion means includes a variable gain analog amplifier (4) and a subsequent AID-converter (8), said converter having a single constant conversion factor.

7. Apparatus according to claim 4, 5 or 6, characterized by a non-volatile memory (12) connected to a control input of said computer (10) and storing a digital value corresponding to the predetermined overall system gain as well as selectable gain values of the variable gain amplifying and conversion means (4, 8); and multiplier circuitry within said computer (10) for multiplying the digital representation by a factor corresponding to the difference between the predetermined overall system gain and the selected gain of the variable gain amplifying and conversion means (4, 8).

8. An apparatus according to one of the claims 4 to 7, characterized by a digital-to-analog converter (18) connected to the signal output of said computer (10) for converting the digital output signal into an analog output signal, preferably within the range of 4 to 20 mA.

## Patentansprüche

1. Verfahren zum Steuern der Verstärkung eines Verstärkersystems mit einer Verstärkereinrichtung (4) veränderbaren Verstärkungsgrades, einerA/D-Umsetzeinrichtung (8) sowie einem Digitalrechner (10), wobei
a) die Systemeingangssignale einem Eingang der Verstärkereinrichtung mit veränderbarem Verstärkungsgrad zugeführt werden;
b) der Ausgang der Verstärkereinrichtung überdieA/D-Umsetzeinrichtung mit dem Digitalrechner in Verbindung steht;
c) ein Ausgangssignal des Digitalrechners zur Steuerung des Verstärkungsgrads der Verstärkereinrichtung mit veränderbarem Verstärkungsgrad benutzt wird;
d) der Gesamtverstärkungsgrad des Verstärkungssystems in einen von der mit variablem Verstärkungsgrad arbeitenden Verstärkungs-und Analog/Digital-Umsetzeinrichtung (4, 8) bereitgestellten ersten Verstärkungsanteil und in einen vom Digitalrechner (10) bereitgestellten zweiten Verstärkungsteil aufgeteilt ist;
e) das Ausgangssignal derVerstärkungs- und Umsetzeinrichtung eine digitale Darstellung des verstärkten Eingangssignals ist und als Eingangssignal dem Digitalrechner zugeleitet wird;
f) der Digitalrechner ein Verstärkungssteuersignal für die Steuerung des Verstärkungsgrades der Verstärkungs- und Umsetzeinrichtung derart auswählt, daß diese Verstärkungs- und Umsetzeinrichtung mit variablem Verstärkungsgrad in ihrem linearen Arbeitsbereich betrieben wird;
g) das verstärkte Systemausgangssignal an einem Signalausgang des Digitalrechners abgegriffen wird;
dadurch gekennzeichnet, daß
h) der Digitalrechner das Verstärkungssteuersignal in Abhängigkeit vom Wert der digitalen Darstellung des verstärkten Eingangssignals am Ausgang der A/D-Umsetzeinrichtung (8) auswählt;
i) der Digitalrechner in Abhängigkeit von dem für die Verstärkungs- und Umsetzeinrichtung mit variablem Verstärkungsgrad ausgewählten Verstärkungsgrad im Rechner einen zugeordneten Verstärkungsgrad für dessen digitales Eingangssignal derart auswählt, daß der Gesamtverstärkungsgrad des Verstärkerssystems auf einem vorgegebenen, konstanten Gesamtsystem-Verstärkungswert gehalten wird.

2. Verfahren nach Anspruch 1, gekennzeichnet durch Abspeichern des gewünschten vorgegebenen Gesamtsystem-Verstärkungswertes sowie der verfügbaren Verstärkungswerte der Verstärkungs- und Umsetzeinrichtung (4, 8) mit variablem Verstärkungsgrad in einem dem Rechner zugeordneten Speicher (12) und Versorgung des Digitalrechners (10) mit einem Steuersignal, welches zusammen mit dem ausgewählten Verstärkungsgrad der Verstärkungs- und Umsetzeinrichtung den gewünschten vorgegebenen Gesamtsystem-Verstärkungswert erzielt.

3. Verfahren nach Anspruch 1 oder 2, gekennzeichnet durch Auswahl des Verstärkungsgrades der Verstärkungs- und Umsetzeinrichtung (4, 8) mit variablem Verstärkungsgrad derart, daß ihr Ausgangssignal einen vorgegebenen Wert nicht überschreitet, und durch Vergrößern der von dieser Einrichtung gelieferten digitalen Darstellung mit Hilfe des Rechners (10), um den vorgegebenen Gesamtverstärkungsgrad des Systems zu erzielen.

4. Signalverarbeitungssystem zur Durchführung des Verfahrens nach einem der vorangehenden Ansprüche, mit
a) einer Verstärkungs- und Umsetzeinrichtung (4, 8) mit variablem Verstärkungsgrad;
b) einem Digitalrechner (10) zur Verstärkungssteuerung der Verstärkungs- und Umsetzeinrichtung; sowie
c) einem Ausgang, der das verstärkte Eingangssignal liefert; wobei
d) die Verstärkungs- und A/D-Umsetzeinrichtung (4, 8) mit variablem Verstärkungsgrad mehrere auswählbare Signalverstärkungswerte aufweist;
e) das analoge Systemeingangssignal einem Signaleingang der Verstärkungs- und Umsetzeinrichtung (4, 8) zugeführt wird und eine digitale Darstellung des verstärkten Eingangssignals an einem Ausgang der Verstärkungs- und Umsetzeinrichtung ansteht und von dort einem Signaleingang des Digitalrechners (10) zugeführt wird;
f) der Digitalrechner (10) an einem Steuerausgang (16) ein Verstärkungsgrad-Auswahlsignal solcher GröRe für die Verstärkungsregelung der Verstärkungs- und Umsetzeinrichtung (4, 8) liefert, daß diese in ihrem linearen Arbeitsbereich betrieben wird;
g) eine Ausgangsschaltung (18) des Digitalrechners (10) ein Systemausgangssignal liefert;
dadurch gekennzeichnet, daß
h) der Digitalrechner das Verstärkungssteuersignal in Abhängigkeit von der digitalen Darstellung des verstärkten Systemeingangsignals am Ausgang der A/D-Umsetzeinrichtung (8) auswählt;
i) der Digitalrechner in Abhängigkeitvom ausgewählten Verstärkungsgrad der Verstärkungs-und Umsetzeinrichtung seinen eigenen Verstärkungsgrad derart einstellt, daß der Gesamtverstärkungsgrad des Systems auf einem vorgegebenen konstanten Gesamtsystem-Verstärkungswert gehalten wird, und das Systemausgangssignal dem Systemeingangssignal multipliziert mit dem vorgegebenen kostanten Gesamtverstärkungsfaktor entspricht.

5. Gerät nach Anspruch 4, dadurch gekennzeichnet, daß die Verstärkungs- und Analog/Digital-Umsetzeinrichtung ein A/D-Umsetzer (8) mit mehreren auswählbaren Signalverstärkungsfaktoren ist.

6. Gerät nach Anspruch 4, dadurch gekennzeichnet, daß die Verstärkungs- und Analog/Digital-Umsetzeinrichtung einen Analogverstärker (4) mit variablem Verstärkungsgrad und einen nachgeschalteten A/D-Umsetzer (8) aufweist, welcher einen einzigen konstanten Umsetzfaktor hat.

7. Gerät nach Anspruch 4, 5 oder 6, gekennzeichnet durch einen an einen Steuereingang des Digitalrechners (10) angeschlossenen, nichtflüchtigen Speicher (12) und Speicherung eines Digitalwerts entsprechend dem vorgegebenen Gesamtsystemverstärkungsgrad sowie auswählbarer Verstärkungswerte der Verstärkungs- und Umsetzeinrichtung (4, 8) mit variablem Verstärkungsgrad; und durch eine Multipliziererschaltung im Digitalrechner (10) zum Multiplizieren der digitalen Darstellung mit einem Faktor entsprechend der Differenz zwischen dem vorgegebenen Gesamtsystem-Verstärkungsgrad und dem ausgewählten Verstärkungsgrad der Verstärkungs- und Umsetzeinrichtung (4,8) mit veränderbarem Verstärkungsgrad.

8. Gerät nach einem der Ansprüche 4 bis 7, gekennzeichnet durch einen an den Signalausgang des Digitalrechners (10) angeschlossenen Digital/Analog-Umsetzer (18) zur Umwandlung des digitalen Ausgangssignals in ein analoges Ausgangssignal, vorzugsweise im Bereich von 4 bis 20 mA.

## Revendications

1. Procédé pour commander le gain d'un système amplificateur comprenant des moyens d'amplification à gain variable (4), des moyens de conversion analogique-numérique (8) et un calculateur numérique (10) , dans lequel :
(a) des signaux d'entrée sont appliqués à une entrée de signal des moyens d'amplification à gain variable ;
(b) la sortie desdits moyens d'amplification est en communication avec le calculateur numérique par l'intermédiaire des moyens de conversion analogique-numérique;
(c) un signal de sortie du calculateur numérique est utilisé pour commander le gain des moyens d'amplification à gain variable ;
(d) le gain total du système d'amplification est divisé en une première partie de gain fournie par les moyens d'amplification à gain variable et les moyens de conversion analogique-numérique (4,8) et une seconde partie de gain fournie par le calculateur numérique (10);
(e) le signal de sortie des moyens d'amplification et de conversion est une représentation numérique du signal d'entrée amplifié, laquelle représentation numérique est appliquée en tant que signal d'entrée audit calculateur numérique ;
(f) le calculateur numérique choisit un signal de commande de gain en vue de commander le gain des moyens d'amplification à gain variable et de conversion, de sorte que ces moyens d'amplification à gain variable et de conversion fonctionnent dans une gamme linéaire ;
(g) le signal de sortie de système amplifié est prélevé d'un signal de sortie du calculateur numérique ; caractérisé en ce que :
(h) le calculateur numérique choisit ledit signal de commande de gain en fonction de la valeur de ladite représentation numérique du signal d'entrée amplifié comme fourni à la sortie des moyens de conversion analogique-numérique (8);
(i) selon le gain choisi pour les moyens d'amplification à gain variable et de conversion, le calculateur numérique choisit un gain associé dans le calculateur numérique pour son signal d'entrée numérique de sorte que le gain total du système est maintenu à un niveau de gain de système total constant prédéterminé.

2. Procédé selon la revendication 1, caractérisé par le stockage dans une mémoire d'ordinateur (12) du gain de système total prédéterminé désiré et des gains de signal disponibles des moyens d'amplification à gain variable et de conversion (4,8) et par l'application au calculateur numérique (10) d'un signal de commande qui , en même temps que le gain choisi des moyens de conversion et d'amplification à gain variable, procure le gain de signal total prédéterminé souhaité.

3. Procédé selon l'une des revendications 1 ou 2, caractérisé par le choix du gain des moyens de conversion et d'amplification à gain variable (8,4) de sorte que son signal de sortie ne dépasse pas une valeur prédéterminée et par l'augmentation de la représentation numérique fournie par lesdits moyens de conversion et d'amplification à gain variable en utilisant le calculateur numérique

(10) en vue de réaliser le gain total prédéterminé du système.

4. Système amplificateur de signal pour mettre en oeuvre le procédé selon l'une quelconque des revendications précédentes , ledit système comprenant :
a) des moyens d'amplification à gain variable et de conversion (4,8 );
b) un calculateur numérique (10) commandant le gain des moyens d'amplification et de conversion; et
c) une sortie délivrant le signal d'entrée amplifié ; dans lequel :
d) les moyens d'amplification à gain variable et de conversion analogique-numérique (4,8) comportent plusieurs gains de signal sélectionnables ;
e) le signal d'entrée du système analogique est appliqué à une entrée de signal des moyens d'amplification et de conversion (4,8) et une représentation numérique du signal d'entrée d'amplifié fournie à une sortie des moyens d'amplification et de conversion est appliquée à une entrée de signal du calculateur numérique (10);
f) le calculateur numérique (10) fournit en une sortie de commande (16) un signal de commande de gain en vue de commander le gain des moyens d'amplification et de conversion (4,8) de sorte que ceux-ci fonctionnent dans leur gamme linéaire ;
g) des moyens de sortie de signal (18) du calculateur numérique (10) fournissent un signal de sortie de système ; caractérisé en ce que :
h) le calculateur numérique (10) choisit ledit signal de commande de gain en fonction de la valeur de ladite représentation numérique du signal d'entrée de système amplifié comme fourni à la sortie des moyens de conversion analogique-numérique (8);
(i) selon le gain choisi pour les moyens d'amplification et de conversion, le calculateur numérique règle son propre gain de sorte que le gain total du système est maintenu à un niveau de gain de système total constant prédéterminé, et le signal de sortie de système correspond à un signal d'entrée de système amplifié par le nombre de fois le facteur de gain total constant prédéterminé.
